# EUROPEAN PATENT APPLICATION

(11) **EP 3 054 493 A1**
(43) Date of publication of application: **10.08.2016**
(21) Application number: 14847378.8
(22) Date of filing: 12.06.2014
(51) Int. Cl.: H01L 35/32, H01L 35/14, H01L 35/16, H01L 35/22, H02N 11/00

(54) **THERMOELECTRIC CONVERSION MODULE**

(30) Priority: 30.09.2013 JP 2013205420
(71) Applicant: Nippon Thermostat Co., Ltd., Kiyose-shi Tokyo 204-0003 (JP)
(72) Inventor: SUDA Hiroshi, Kiyose-shi Tokyo 204-0003 (JP); NEMOTO Takashi, Kiyose-shi Tokyo 204-0003 (JP); SATO Junichi, Kiyose-shi Tokyo 204-0003 (JP)
(74) Representative: Jannig, Peter
(86) International application number: PCT/JP2014/065653
(87) International publication number: WO 2015/045500

(57) **Abstract**

A thermoelectric conversion module (1) that provides improved reliability while maintaining good induced voltage. The thermoelectric conversion module (1) includes a base (5); a plurality of first electrodes (3); a plurality of thermoelectric conversion elements (2) each electrically connected to one of the first electrodes (3) at one end thereof; and a plurality of second electrodes (4), each electrically connected to another end of the thermoelectric conversion elements (2); a plurality of parallel groups (17) connecting the thermoelectric conversion elements (2) in parallel; and the parallel groups (17) connected in series, or a plurality of series groups (17') connecting the thermoelectric conversion elements (2) in series, with the series groups (17') connecting in parallel.

## Description

### Technical Field

The present invention relates to a thermoelectric conversion module that uses the Seebeck effect to generate electricity and the Peltier effect to carry out heating and cooling.

### Background Art

Conventionally, a thermoelectric conversion module that arranges a plurality of thermoelectric conversion elements each having an electrode at both ends is known (see, for example, Patent Document 1).

The thermoelectric conversion module of Patent Document 1 is composed of a so-called pi-type thermoelectric conversion module consisting of two types of thermoelectric conversion elements, n-type thermoelectric conversion elements and p-type thermoelectric conversion elements, arranged in alternating sequence and electrically connected in series.

With the thermoelectric conversion module of Patent Document 1, the hot side of the thermoelectric conversion module is made contactless with respect to the heat chamber inside the resistance heating furnace covered in heat insulating material. The hot side of the thermoelectric conversion module is susceptible to the radiant heat transferred from the heat chamber. Therefore, in the thermoelectric conversion module of Patent Document 1, a base as an insulator for the hot side is omitted. It should be noted that when the hot side of the thermoelectric conversion module is contacted against the heat chamber inside the resistance heating furnace, the base is provided as an insulator.

A so-called uni-leg-type thermoelectric conversion module, consisting of only one type of thermoelectric conversion element, either the n-type or the p-type, is also known (see, for example, Patent Document 2).

The thermoelectric conversion module of Patent Document 2 has a connecting part that connects one of the electrodes of the thermoelectric conversion element with the other electrode of the adjacent thermoelectric conversion element integrally and electrically in series, and is composed of a U-shaped connector consisting of the two electrodes and the connecting part. The U-shaped connector is formed of sheet metal that is bent into shape. When manufacturing the thermoelectric conversion module, a plurality of these U-shaped connectors are fixedly mounted in advance on the base. Then, the thermoelectric conversion elements are pushed into the U-shaped connector from the side and inserted between the two electrodes, thus connecting the electrodes to the connector.

### Prior Art Documents

### Patent Documents

Patent Document 1: JP-4834986-B
Patent Document 2: JP-2009-176919-A

### SUMMARY OF THE INVENTION

### Technical Problem

Using the Seebeck effect to generate electricity with thermoelectric conversion elements results in very low induced voltages. As a result, for commercialization it is necessary to connect the thermoelectric conversion elements in series to obtain a sufficient voltage. However, connecting thermoelectric conversion elements in series means that no current flows if any one of the thermoelectric conversion elements is damaged, thus rendering the whole module unusable. There is thus a problem of reliability.

The present invention is conceived in light of the above-described problem, and has as its object to provide a thermoelectric conversion module that can provide improved reliability while securing a sufficient induced voltage.

### Solving the Technical Problem

[1] To achieve the above-described object, the present invention provides a thermoelectric conversion module comprising a plurality of first electrodes; a plurality of thermoelectric conversion elements, each electrically connected to one of the first electrodes at one end thereof; and a plurality of second electrodes, each electrically connected to another end of the thermoelectric conversion elements, with a plurality of series groups connecting the thermoelectric conversion elements in series and the series groups connected in parallel.
   According to the present invention, because it connects in parallel a plurality of series groups that connect the thermoelectric conversion elements in series, even if one of thermoelectric conversion elements of the series group malfunctions electricity can still be generated by the thermoelectric conversion elements of other series groups, thereby improving reliability. In addition, the induced voltage of the thermoelectric conversion module can be increased because the thermoelectric conversion elements of the series groups are connected in series.
[2] The present invention also provides a thermoelectric conversion module comprising a plurality of first electrodes; a plurality of thermoelectric conversion elements, each electrically connected to one of the first electrodes at one end thereof; and a plurality of second electrodes, each electrically connected to another end of the thermoelectric conversion elements, with a plurality of parallel groups connecting the thermoelectric conversion elements in parallel and the parallel groups connected in series.
   According to the present invention, because it connects in series the plurality of parallel groups that connect thermoelectric conversion elements in parallel, even if one of thermoelectric conversion elements of the series group malfunctions electricity can still be generated by the thermoelectric conversion elements of other series groups, thereby improving reliability. In addition, the parallel groups are connected in series. As a result, the induced voltage of the thermoelectric conversion module can be increased.
[3] In the present invention, the thermoelectric conversion module comprises a pair of terminal parts to input and output electricity, with one of the pair of terminal parts positioned adjacent another terminal part of an adjacent thermoelectric conversion module when a plurality of thermoelectric conversion modules are aligned, and the other of the pair of terminal parts and the other terminal part of the adjacent thermoelectric conversion module linkable by a binding member.
   According to the present invention, a plurality of thermoelectric conversion modules can be linked together and used as a single thermoelectric conversion module, facilitating easy alteration of the installation area of the thermoelectric conversion module while maintaining a high degree of element density.
[4] In the present invention, a guide that positions the thermoelectric conversion elements is provided to either the first electrodes or the second electrodes. According to the present invention, when the thermoelectric conversion elements are connected to the first electrode or the second electrode they are positioned in place by the guides, thus preventing erroneous connection (misalignment) of the thermoelectric conversion elements to the first electrodes or the second electrodes and enabling quick assembly of the thermoelectric conversion module.
[5] In the present invention, the first electrodes or the second electrodes are formed of a member containing a layer of brazing material. According to the present invention, the step of providing brazing material at portions where the first electrodes or the second electrodes and the thermoelectric conversion elements are bonded together can be eliminated, thus facilitating easy production of the thermoelectric conversion module.
[6] In the present invention, the thermoelectric conversion module comprises a base on which are arranged either the first electrodes or the second electrodes. Preferably, the base is divided into a plurality of sub-substrates. According to the present invention, by dividing the base the size of the base can be easily altered, thus eliminating the need to remake the base every time the size of the thermoelectric conversion module is changed.
[7] In the present invention, preferably the base is divided by the parallel groups or the series groups. The present invention increases the number of parallel groups and series groups and further facilitates alterations in the size of the thermoelectric conversion module due to an increase in the number of bases.
[8] In the present invention, preferably the plurality of thermoelectric conversion elements are composed of one of either n-type or p-type thermoelectric conversion elements, and the thermoelectric conversion module comprises a connector that electrically connects the first electrodes and the second electrodes electrically connected to adjacent thermoelectric conversion elements, wherein a tracking portion is provided to the connector and is configured to heighten an ability of the connector to track deformation of the thermoelectric conversion module due to thermal expansion and thermal contraction of the thermoelectric conversion elements. According to the present invention, even if the thermoelectric conversion elements deform due to thermal expansion or thermal contraction, the tracking portion can track that deformation.
[9] In the present invention, preferably the plurality of thermoelectric conversion elements are composed of n-type and p-type thermoelectric conversion elements, adjacent n-type thermoelectric conversion elements and p-type thermoelectric conversion elements are connected by either first electrodes or second electrodes connected to each other, and the first electrodes and second electrodes connected to each other by an absorbing part that absorbs deformation due to thermal expansion of the thermoelectric conversion elements, the absorbing part connecting adjacent ends of the first electrodes or the second electrodes after bending from one end of the first electrode or the second electrode back toward the other of the first electrode and the second electrode. According to the present invention, the absorbing part can absorb any difference in the coefficient of thermal expansion between the n-type thermoelectric conversion elements and the p-type thermoelectric conversion elements.
[10] In the present invention, preferably the thermoelectric conversion module comprises a pair of terminal parts to input and output electricity, wherein at least one of the terminal parts is provided to the first electrodes or the second electrodes electrically connected to the parallel groups or the series groups via a bent part that is bent along a side edge of one of the parallel group or the series group and which suppresses a rise in temperature of at least one of the terminal parts.
   According to the present invention, the bent part can minimize states in which the temperature difference between the two ends of the thermoelectric conversion elements cannot be adequately maintained due to radiant heat from the terminal parts.
[11] In the present invention, the plurality of first electrodes are provided so that each first electrode corresponds to a corresponding one of the thermoelectric conversion elements, and wherein the second electrodes are fixedly mounted on the base.
   According to the present invention, because the first electrodes are provided so that each first electrode corresponds to a corresponding one of the thermoelectric conversion elements, the interval between adjacent first electrodes can be expanded, so that deformation due to thermal expansion and thermal contraction of the thermoelectric conversion elements can be absorbed on the first electrode side.
[12] In the present invention, the second electrodes are formed into integrated units corresponding to the parallel groups.

According to the present invention, by forming the second electrodes into integrated units corresponding to the parallel groups, the plurality of second electrodes connected to the thermoelectric conversion elements can be installed all at once, thus simplifying assembly of the thermoelectric conversion module.

### BRIEF DESCRIPTION OF THE DRAWINGS

FIG. 1 is a perspective view of a thermoelectric conversion module according to a first embodiment of the present invention;
FIG. 2 is a perspective view of the thermoelectric conversion module of FIG. 1 from a different direction;
FIG. 3 is an exploded view of the thermoelectric conversion module according to the first embodiment;
FIG. 4 is a perspective view of a plurality of thermoelectric conversion modules of the first embodiment coupled together;
FIG. 5 is a perspective view of the thermoelectric conversion modules of FIG. 4 separated;
FIG. 6 is an explanatory diagram of a variation of the thermoelectric conversion module according to the first embodiment;
FIG. 7 is a perspective view of a thermoelectric conversion module according to a second embodiment of the present invention;
FIG. 8 is a perspective view of the thermoelectric conversion module of FIG. 7 from a different direction;
FIG. 9 is an exploded view of the thermoelectric conversion module according to the second embodiment;
FIG. 10 is a perspective view of a connector that connects the first electrode and the second electrode of the second embodiment;
FIG. 11 is a cross-sectional view along line XI-XI in FIG. 10;
FIG. 12 is a perspective view of a thermoelectric conversion module according to a third embodiment of the present invention;
FIG. 13 is a perspective view of the thermoelectric conversion module of FIG. 12 from a different direction;
FIG. 14 is an exploded view of the thermoelectric conversion module according to the third embodiment;
FIG. 15 is a perspective view of a thermoelectric conversion module according to a fourth embodiment of the present invention;
FIG. 16 is a perspective view of the thermoelectric conversion module of FIG. 15 from a different direction; and
FIG. 17 is an exploded view of the thermoelectric conversion module according to the fourth embodiment.

### DETAILED DESCRIPTION OF EMBODIMENTS OF THE INVENTION

### First Embodiment

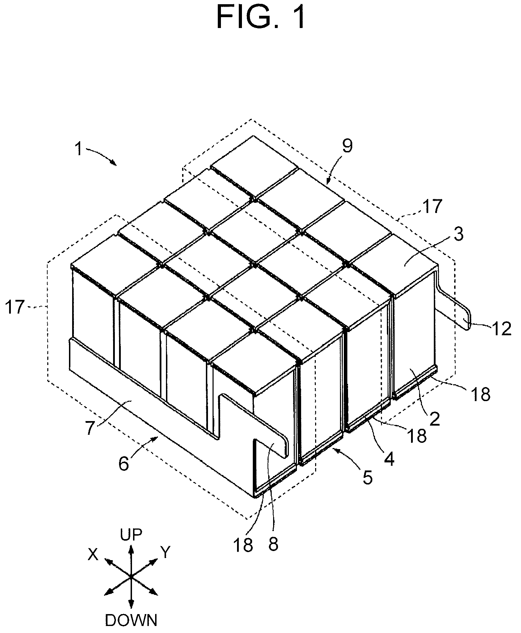

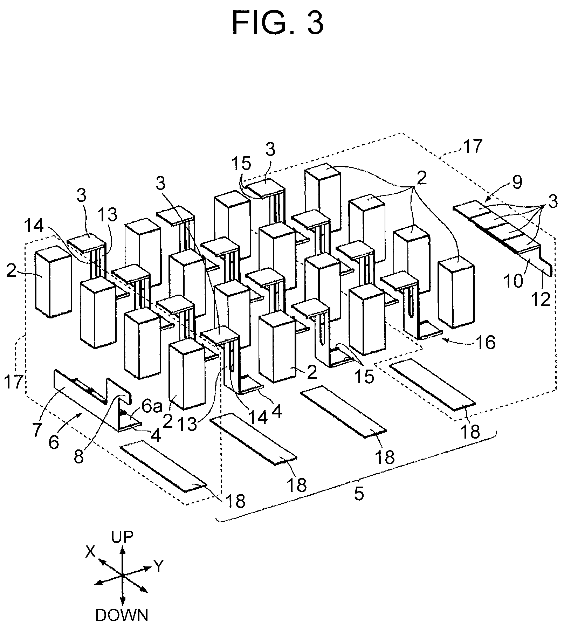

With reference to FIG. 1 through FIG. 5, a description is given of a first embodiment of a thermoelectric conversion module of the present invention. The thermoelectric conversion module shown in FIG. 1 though FIG. 3 is a so-called uni-leg type, in which a plurality of n-type thermoelectric conversion elements 2 are electrically connected.

The thermoelectric conversion elements 2 are made of magnesium silicide (Mg₂Si), shaped into square columns. Conventionally, many of the materials used for thermoelectric conversion elements are toxic (including materials that may become toxic) as well as expensive. By contrast, Mg₂Si is not toxic and is environmentally friendly, and moreover is plentiful and inexpensive. In addition, Mg₂Si has a low specific gravity, thus allowing very lightweight thermoelectric conversion elements to be produced. For these reasons, Mg₂Si has become the material of choice for thermoelectric conversion elements.

First electrodes 3 are bonded to the top ends of the thermoelectric conversion elements 2, thus electrically connecting the thermoelectric conversion elements 2 and the first electrodes 3. Second electrodes 4 are bonded to the bottom ends of the thermoelectric conversion elements 2, thus electrically connecting the thermoelectric conversion elements 2 and the second electrodes 4.

The surfaces of the first electrodes 3 and the second electrodes 4 that are connected to the thermoelectric conversion elements 2 are made of nickel plate (Ni) containing a layer of brazing material. The first electrodes 3 and the second electrodes 4 may themselves be formed with a layer of brazing material; alternatively, the brazing material may be screen-printed onto the surface of the nickel plate and the plate punched out in the shapes of the first electrodes 3 and the second electrodes 4.

Use of the first electrodes 3 and the second electrodes 4 constructed in this way eliminates the need to print out the brazing material for each and every one of the first electrodes 3 and the second electrodes 4, thereby reducing the number of printings of brazing material and thus simplifying the manufacturing process.

It should be noted that the material for the electrodes 3, 4 is not limited to nickel (Ni) and may be, for example nickel (Ni) -plated copper (Cu) or some other material. In addition, as for the method of bonding the electrodes to the thermoelectric conversion elements, this may be accomplished by soldering using solder or brazing, or by adhesion or diffusion bonding with an electrically conductive adhesive such as silver paste, with the choice of method depending on the intended application of the thermoelectric conversion module.

In the case of bonding by soldering, the brazing (solder) can be pre-pasted onto the two ends of the thermoelectric conversion element 2. However, in the present embodiment, electrodes 3, 4 made of a planar material containing a layer of brazing material are used as the surfaces (that is, one or both ends) of the element. The surfaces of the thermoelectric conversion elements 2 contain minute irregularities that make them uneven but which can be made smooth by covering them with brazing (solder) or silver paste to provide a better bond between the thermoelectric conversion elements 2 and the electrodes 3, 4 and ensure superior electrical conductivity. Alternatively, when manufacturing the thermoelectric conversion elements 2, a bonding layer of nickel or the like may be formed on both ends (top and bottom ends) of the thermoelectric conversion elements 2 to facilitate bonding between the thermoelectric conversion elements 2 and the electrodes 3, 4.

The second electrode 4 is fixedly mounted on a planar base 5. The base 5 is a planar body made of aluminum oxide and having insulating properties. The material for the body 5 is not limited to aluminum oxide and may be some other material instead. In the thermoelectric conversion module 1 of the present embodiment, the bottom is used as the hot side and the top is used as the cold side.

In addition, in the drawings, the upper base is removed in order to make the interior of the thermoelectric conversion module 1 easier to see. It should be noted that although the upper base is necessary in order to prevent short-circuiting when contacting the thermoelectric conversion module 1 against something that has an exterior that is electrically conductive like metal, the upper base can be omitted if the object against which the thermoelectric conversion module 1 is contacted is insulated or if the thermoelectric conversion module 1 is configured so as to radiate heat (i.e., cool) without contact. The material of the base can be selected as appropriate depending on the object against with the thermoelectric conversion module 1 is contacted. For example, the upper base may be made of a flexible, electrically insulating, heat conductive sheet. Alternatively, the thermoelectric conversion module 1 may be configured so as to omit the lower base 5, leaving just the upper base. Yet alternatively, both the upper and lower bases may be omitted.

The X direction and Y direction are as defined in FIG. 1. In the thermoelectric conversion module 1 of the present embodiment, four thermoelectric conversion elements 2 are arrayed in the X direction and four thermoelectric conversion elements 2 are arrayed in the Y direction, for a total of 16 thermoelectric conversion elements 1.

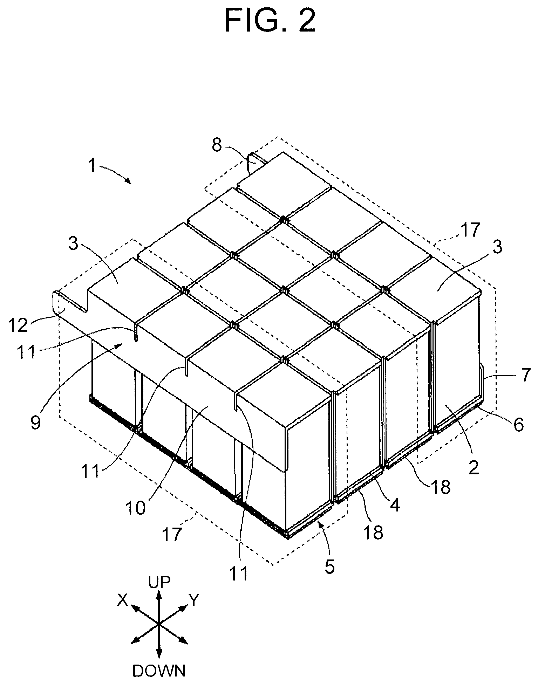

As shown in the exploded view of FIG. 3, the four second electrodes 4 that are electrically connected to the four thermoelectric conversion elements 2 arrayed in the X direction on the proximal end of the thermoelectric conversion module 1 of the present embodiment (the distal end in FIG. 2) are configured as an integrally formed integrated second electrode 6.

A bent part 7 bent upward is provided in the Y direction side of the integrated second electrode 6. An L-shaped first terminal part 8 is provided on the proximal front edge of the bent part 7. The first terminal part 8 is shaped so that the L-shaped tip portion is positioned at the top (the cold side) of the thermoelectric conversion elements 2. As a result, the first terminal part 8 is separated from the heat source (the hot side) and an increase in temperature of the first terminal part 8 can be minimized, thus preventing an increase in electrical resistance of the first terminal part 8 attendant upon a rise in temperature. The tip portion of the L shape of the first terminal part 8 extends further outward than does the base 5.

Providing the bent part 7 allows the cross-sectional area necessary for the current to flow through the first terminal part 8 to be made smaller. Therefore, by providing the bent part 7, the surface area of the first terminal part 8 can be made smaller, so that the temperature difference between the two ends of the thermoelectric conversion element 2 due heat being propagated from the hot side and to the effect of radiant heat from the first terminal part 8 heating up from the flow of electric current can be minimized.

A recessed portion 6a recessed so as to accommodate the thermoelectric conversion elements 2 is provided on that portion of the integrated second electrode 6 which is electrically connected to the thermoelectric conversion elements 2. The recessed portion 6a acts to position the thermoelectric conversion elements 2 when they are fixedly mounted to the integrated second electrode 6, thereby preventing the thermoelectric conversion elements 2 from being incorrectly bonded to the integrated second electrode 6 and thus facilitating speedy assembly of the thermoelectric conversion module 1.

In addition, providing the recessed portion 6a eliminates the need to use a separate jig to position the thermoelectric conversion elements 2 as well as eliminates the space needed for the jig, thereby improving the density of the thermoelectric conversion elements 2 per unit surface area of the base 5. The recessed part 6a functions as a guide of the present invention in the integrated second electrode 6 of the present embodiment.

Again as shown in the exploded view of FIG. 3, the four first electrodes 3 that are electrically connected to the four thermoelectric conversion elements 2 arrayed in the X direction on the distal end of the thermoelectric conversion module 1 of the present embodiment (the proximal end in FIG. 2) are configured as an integrally formed integrated first electrode 9.

A bent part 10 bent downward is provided in the Y direction side of the integrated first electrode 9. The individual first electrodes 3 of the integrated first electrode 9 are connected via the bent part 10. Slits 11 located between individual first electrodes 3 are formed in the bent part 10, extending downward from the top edge of the bent part 10 downward

A second terminal part 12 corresponding to the first electrode part 8 is provided on the proximal end (the distal end in FIG. 2) of the bent part 10 in the X direction.

The first electrodes 3 other than the integrated first electrode 9 are integrally formed in substantially a Z shape via the second electrodes 4 electrically connected to adjacent thermoelectric conversion elements 2 in the Y direction and connectors 13. A cutout 14 is provided in the center of each of the connectors 13. The cutout 14 reduces to a necessary minimum the cross-sectional area of the connector 13 with respect to the electric current that flows through the connector 13, thereby minimizing the heat that is propagated from the hot side to the cold side in the connector 13 and thus preventing a reduction in the temperature difference between the two ends of the thermoelectric conversion element 2.

A folded part 15 folded back toward the thermoelectric conversion element 2 from the side edge in the X direction is provided to the first electrode 3 and the second electrode 4 connected by the connector 13. The folded part 15 is provided opposite the X direction side surface of the thermoelectric conversion element 2, and is used to position the thermoelectric conversion elements 2 with respect to the first electrodes 3 and the second electrodes 4. In the present embodiment, in addition to the recessed portion 6a the folded part 15 also functions as a guide. It should be noted that the folded part 15 may be provided to only one of the first electrode 3 or the second electrode 4, such that, for example, it is not provided to the first electrode 3.

In the present embodiment, the substantially Z-shaped member constructed of the first electrode 3, the second electrode 4, and the connector 13 is defined as Z-shaped member 16.

In the present embodiment, the four thermoelectric conversion elements 2 electrically connected to the integrated second electrode 6 and the four thermoelectric conversion elements 2 electrically connected to the integrated first electrode 9 form parallel groups 17. Two parallel groups 17 are connected in series at four places via three substantially Z-shaped members 16 and two thermoelectric conversion elements 2 arrayed in the Y direction.

The base 5 of the present embodiment is divided in the Y direction into four sub-substrates 18 corresponding to the parallel groups 17. By dividing the base 5 in this manner, the thermoelectric conversion module 1 of the present invention can be easily installed even on convex surfaces that are curved.

Moreover, the size of the base 5 can be changed simply by changing the number of sub-substrates 18, providing greater design freedom. In addition, configuring the base 5 as a plurality of sub-substrates 18 enables changes due to thermal expansion and thermal contraction of the thermoelectric conversion elements 2 to be easily absorbed. Since the sub-substrates 18 of the present embodiment are provided corresponding to the parallel groups 17, the number of sub-substrates 18 can be increased and decreased as the number of parallel groups 17 is increased and decreased, thereby further increasing design freedom of the thermoelectric conversion module 1.

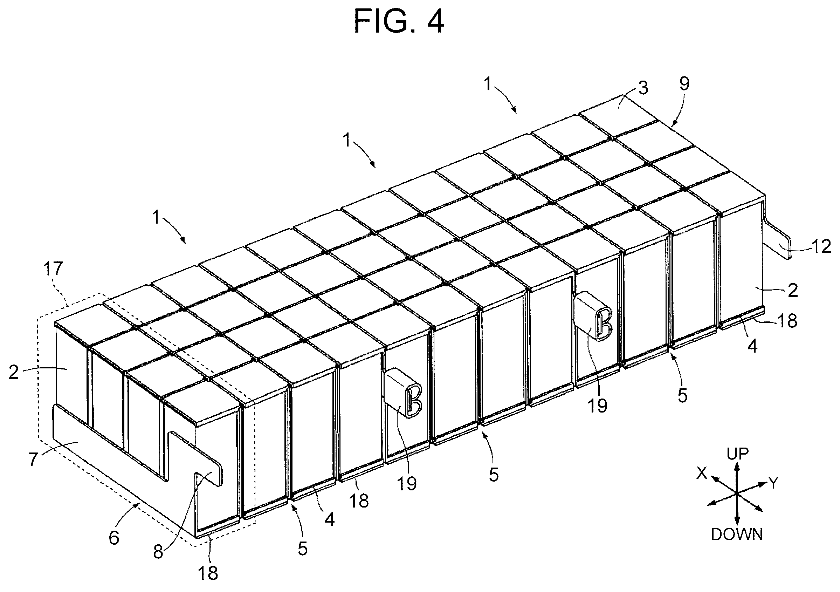

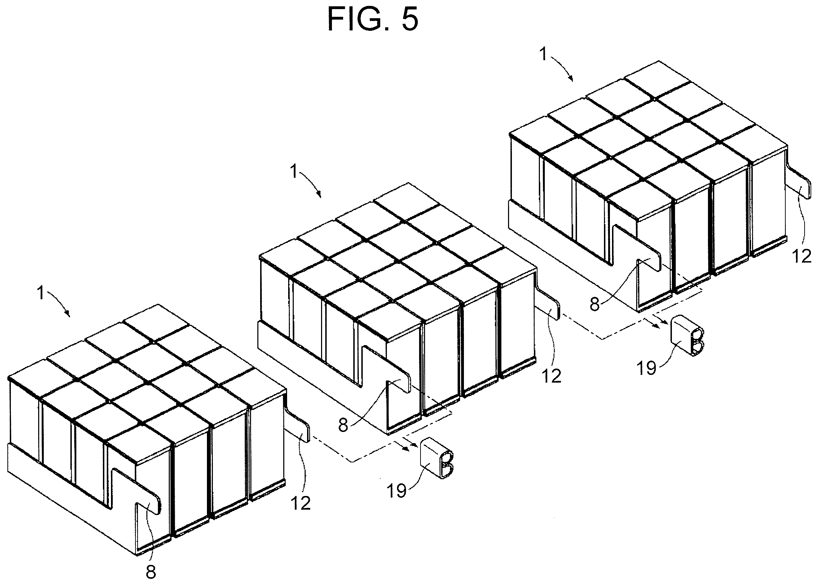

FIG. 4 and FIG. 5 show three of the thermoelectric conversion modules 1 of the present embodiment aligned in the Y direction, with adjacent first terminal parts 8 and second terminal parts 12 bound together by a substantially tubular binding member 19.

With this arrangement, the thermoelectric conversion modules 1 of the present embodiment, by binding together a plurality of overlapping first terminal parts 8 and second terminal parts 12 with the binding member 19, can be configured as if they were a single thermoelectric conversion module the size of which can be easily changed to accommodate the size of the installation location of the thermoelectric conversion module while still maintaining high element density. In other words, with the thermoelectric conversion module 1 of the present embodiment, installation freedom is improved. In addition, dead space between the thermoelectric conversion modules 1 can be held to an absolute minimum, for more compact thermoelectric conversion module 1 assemblies.

Next, a description is given of the operation of the thermoelectric conversion module of the present embodiment. A temperature difference arises when the thermoelectric conversion module 1 is installed with the bottom base 5 on a heat source of, for example 300°C to 600°C and cooling the top base (omitted from the drawings), generating an electric current by the Seebeck effect and thus generating electricity. At this time, in order to continue to generate electricity, it is necessary to continue to maintain a predetermined temperature difference between the two ends of the thermoelectric conversion elements 2. The first embodiment, because it uses Mg₂Si, which has a low thermal conductivity, can maintain a good temperature difference.

With the thermoelectric conversion module of the present embodiment, the two parallel groups 17 are connected in series at four places via three substantially Z-shaped members 16 and two thermoelectric conversion elements 2 arrayed in the Y direction. With this arrangement, even if one of thermoelectric conversion elements 2 of the parallel groups 17 malfunctions the other thermoelectric conversion elements 2 can convert heat into electricity and electricity into heat, thereby improving reliability.

Moreover, because the thermoelectric conversion module 1 of the present embodiment has portions where the thermoelectric conversion elements 2 are connected in series, the induced voltage can be increased. In addition, in the present embodiment, the substantially Z-shaped member 16, the thermoelectric conversion elements 2, and the sub-substrates 18 can be added and removed to change the size of the thermoelectric conversion module 1 in the Y direction to any desired size. Accordingly, the thermoelectric conversion module 1 of the present embodiment can be easily changed in size while still providing improved reliability.

Although in the present embodiment the second electrodes 4 are fixedly mounted on the base 5, a slit is provided in the integrated first electrode 9 and the other first electrodes 3 are provided for each connected thermoelectric conversion element 2 so as to maintain a mutual interval therebetween. Accordingly, deformation due to thermal expansion and thermal contraction of the thermoelectric conversion elements 2 and the base 5 can be absorbed on the first electrode 3 side.

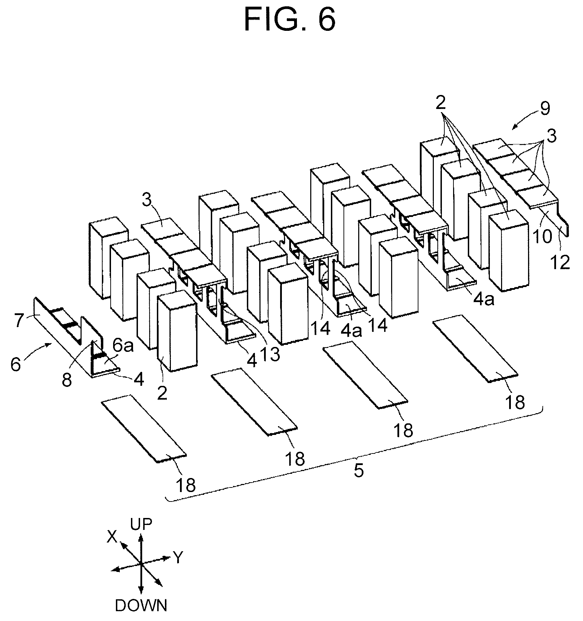

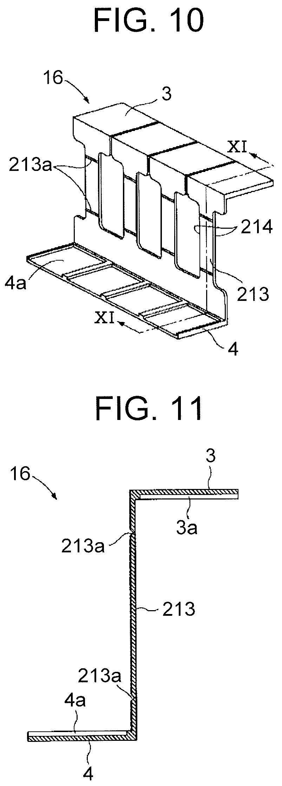

In the present embodiment, the second electrodes 4 of the substantially Z-shaped members 16 are separated at each thermoelectric conversion element 2 in the X direction. Alternatively, however, as shown in the variation depicted in FIG. 6, adjacent second electrodes 4 of the substantially Z-shaped member 16 in the X direction may be formed as a single integrated unit like the integrated second electrode 6. In that case, the thermoelectric conversion elements positioned between two parallel groups 17 of the first embodiment also become a parallel group of four abreast in the X direction. In the variation of the first embodiment shown in FIG. 6, a recess 4a identical to the recess 4a for positioning of the thermoelectric conversion elements 2 to be described below in detail is provided to the second electrodes (see FIG. 10 and FIG. 11).

In the present embodiment, the four thermoelectric conversion elements 2 that are electrically connected to the integrated second electrodes 6 and the four thermoelectric conversion elements 2 that are electrically connected to the integrated first electrode 9 have been described as a parallel group. Alternatively, however, by looking at the thermoelectric conversion module of the present embodiment differently, the two parallel groups 17 can also be defined as configuring individual series groups of the three substantially Z-shaped members 16 and the two thermoelectric conversion elements 2 aligned in the Y direction and connected in series at four places.

In this case, the four series groups are connected in parallel by the integrated second electrode 6 and the integrated first electrode 9. In this case, too, the base 5 may be configured as four sub-substrates divided into four in the X direction, corresponding to the series groups. In this case, in order to change the size of the thermoelectric conversion module it is necessary to change the size of the integrated second electrode and the integrated first electrode. But the size of the thermoelectric conversion module can be changed just by increasing or decreasing the number of series groups in the X direction, thereby providing relatively simply design alteration while still providing improved reliability.

A notched groove 213 of a second embodiment to be described below may be provided to the connectors 13 of the first embodiment. Providing a notched groove to the connectors 13 facilitates vertical expansion and contraction of the connector 13, so that it can more easily track deformations due to thermal expansion and thermal contraction of the thermoelectric conversion elements 2. In addition, even if there appears unevenness in the heights of the thermoelectric conversion elements 2, by deforming the notched grooves the first electrodes 3 can be pressed against the thermoelectric conversion elements 2 to securely bind the thermoelectric conversion elements 2 with the first electrodes 3 and the second electrodes 4. Thus, the notched grooves are the equivalent of a tracking part in the present invention. The tracking parts of the present invention are not limited to notched grooves, however, and may be any configuration that can expand and contract vertically so as to track thermal expansion and thermal contraction of the thermoelectric conversion elements. For example, the tracking parts may be wave-shaped (undulating), V-shaped, or curved.

Although the thermoelectric conversion elements 2 of the present embodiment are shown as square columns in FIG. 2, they are not limited thereto but may be any other shape, such as circular columns.

Although in the first embodiment the thermoelectric conversion elements 2 are made of Mg₂Si, they are not limited thereto. Alternatively, the thermoelectric conversion elements may be made using any thermoelectric conversion material, for example a BiTe compound containing Sb-Te and Bi-Se, a Pb-Te compound containing Sn-Te and Ge-Te, a Ag-Sb-Te compound, a Ag-Sb-Ge-Te compound, a Si-Ge compound, a Fe-Si compound, a Mn-Si compound, a Zn-Sb compound, chalcogenide, skutterudite, filled skutterudite, clathrate, half-Heusler, Heusler, boron carbide, or layered cobalt oxide.

Although the present embodiment has been described using only n-type thermoelectric conversion elements 2, alternatively only p-type thermoelectric conversion elements may be use. Moreover, the Mg2S1 need not be of high purity, and may, for example, be obtained from silicon sludge ejected during grinding and polishing.

A junction layer designed to reduce contact resistance with the electrodes may be provided on the two ends of the thermoelectric conversion elements 2. The junction layer can also be formed integrally with the thermoelectric conversion elements. The junction layer and the electrodes may be composed of Ni, Al, Cu, W, Au, Ag, Co, Mo, Cr, Ti, or Pd, or any material that is an alloy of any of these elements.

Although in the present embodiment a thermoelectric conversion module 1 for generating electricity using the Seebeck effect has been described, the thermoelectric conversion module of the present invention can also be similarly used to cool or heat using the Peltier effect.

In the present embodiment, the bottom side of the thermoelectric conversion module 1 shown in FIG. 1 has been described as the hot side contacted against the heat source and the top side as the cold side that radiates heat (cools). However, the method of using the thermoelectric conversion module 1 of the present invention is not limited thereto, and thus, for example, in FIG. 1, the top side may be the hot side and the bottom side may be the cold side.

The orientation of the first terminal part 8 and the second terminal part 12 can be altered as convenient upon considering whether or not to link thermoelectric conversion modules 1 together with the binding member 19.

### Second embodiment

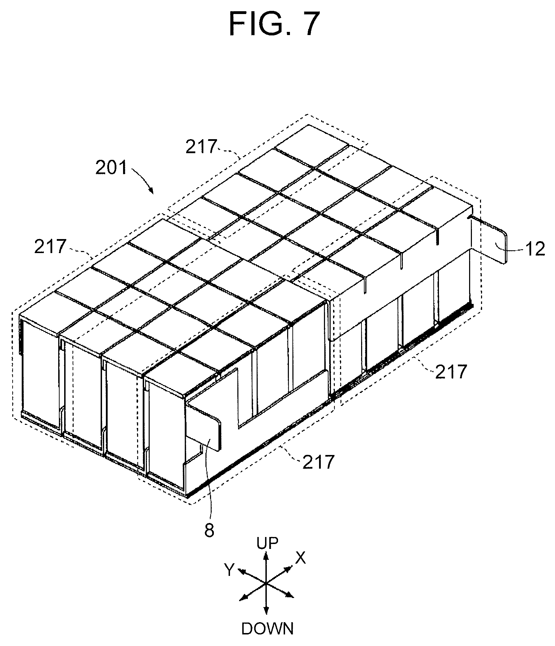

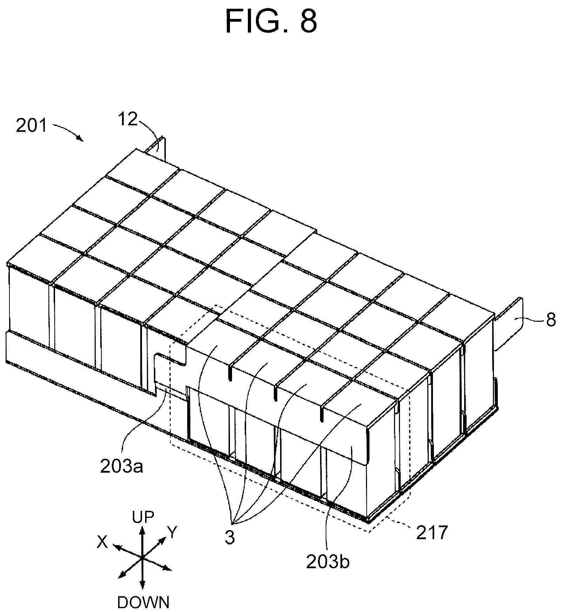

Next, with reference to FIG. 7 to FIG. 11, a description is given of a second embodiment of a thermoelectric conversion module of the present invention. Parts that are identical to those of the first embodiment are given the same reference numerals and descriptions thereof are omitted. Reference numeral 217 in FIG. 7 and FIG. 8 denotes parallel groups of the second embodiment.

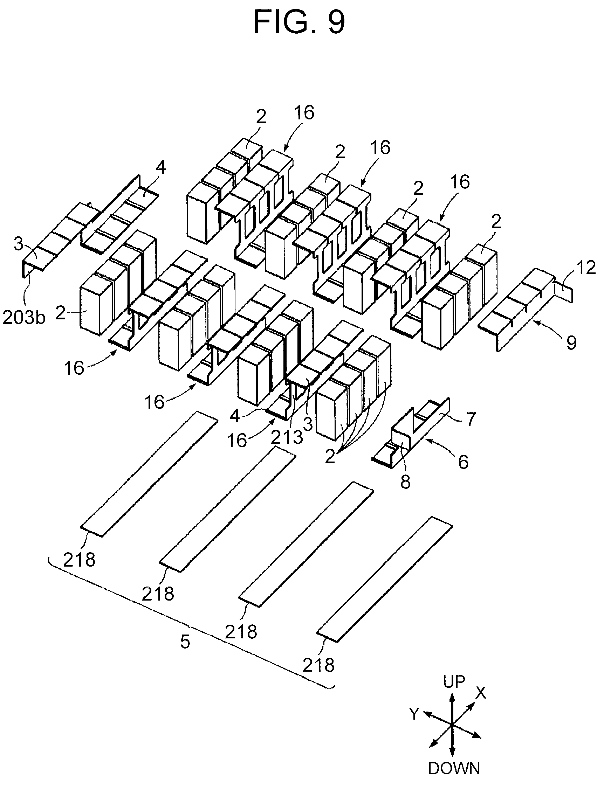

As shown in FIG. 7 through FIG. 9, a thermoelectric conversion module 201 of the second embodiment, as described as a variation of the first embodiment above, forms the second electrodes 4 of the Z-shaped member 16 of the thermoelectric conversion module 1 of the first embodiment as an integrated unit in the X direction (see FIG. 9 through FIG. 11) as well as links two thermoelectric conversion modules 1 of the first embodiment together.

As shown in the proximal end in the Y direction of FIG. 8 (the distal end in the Y direction in FIG. 7 and FIG. 9), the four first electrodes 3 linked together as a single unit in the X direction are linked together with the four second electrodes 4 linked together as a single unit in the X direction (see the exploded view of FIG. 9). The connected portion is provided with a crank part 203a bent in the shape of a crank.

The crank part 203a has a pendulous part 203b depending downward from the proximal side edge in the Y direction in FIG. 8 (in FIG. 7 and FIG. 9, the distal side edge) of the four first electrodes 3 linked together in the X direction, configured to be slightly separated from the thermoelectric conversion elements 2. With such an arrangement, the thermoelectric conversion elements 2 are not readily affected by radiant heat from the pendulous part 203b.

Moreover, with the crank part 203a, a distance in the vertical direction between the four linked first electrodes 3 and the four linked second electrodes 4 is such that thermal expansion and thermal contraction of the thermoelectric conversion elements 2 can be tracked. In other words, in the present embodiment, the crank part 203a is also the equivalent of a tracking part in the present embodiment.

With the thermoelectric conversion module 201 of the second embodiment, the shape of the connector 213 is different from that of the first embodiment. A cutout 14 in which the center of the connector 13 is cut out is provided to the connector 13 of the first embodiment. By contrast, the center of the connector 213 of the second embodiment is left intact and the side edge portions are cut away by a cutout 214.

With the cutout 214 as well, the cross-sectional surface area of the connector 213 is kept to the minimum necessary with respect to the electric current that flows therethrough, thereby minimizing thermal conductivity from the hot side to the cold side in the connector 213 and thus preventing reduction in the temperature difference between the two ends of the thermoelectric conversion elements 2.

Horizontal notched grooves 213a are provided in the surface of the connector 13 in two places at the top and at the bottom of the connector 213, with a space therebetween. Providing notched grooves 213a to the connector 13 facilitates vertical expansion and contraction of the connector 13, so that it can more easily track deformations due to thermal expansion and thermal contraction of the thermoelectric conversion elements 2. In addition, even if there appears unevenness in the heights of the thermoelectric conversion elements 2, by deforming the notched grooves 213a the first electrodes 3 can be pressed against the thermoelectric conversion elements 2 to securely bind the thermoelectric conversion elements 2 with the first electrodes 3 and the second electrodes 4.

Therefore, the notched grooves 213a are the equivalent of a tracking part in the present invention. The tracking parts of the present invention are not limited to notched grooves, however, and may be any configuration that can expand and contract vertically so as to track thermal expansion and thermal contraction of the thermoelectric conversion elements. For example, the tracking parts may be wave-shaped (undulating), V-shaped, or curved.

Thus, the thermoelectric conversion module 2 of the second embodiment also provides the same effects of improved reliability, high induced voltage, and ease of size alteration as the first embodiment does, and the same variations are also applicable.

It should be noted that, as shown in the cross-sectional view of FIG. 11, the second embodiment provides a recess 3a (guide) that positions the thermoelectric conversion elements 2 on the first electrodes 3 that connect to the connector 213 and a recess 4a (guide) that positions the thermoelectric conversion elements 2 on the second electrodes 4 that connect to the connector 213. Alternatively, the recesses 3a, 4a may be provided to only one of the electrodes.

In place of the recess 3a, a folded part that is folded back toward the thermoelectric conversion element 2 side (bottom) on the X direction side edge of the first electrodes 3 similar to the folded part 15 of the first embodiment may be provided. In addition, the orientation of the first terminal part 8 and the second terminal part 12 can be altered as convenient upon considering whether or not to link thermoelectric conversion modules 1 together with the binding member 19.

### Third Embodiment

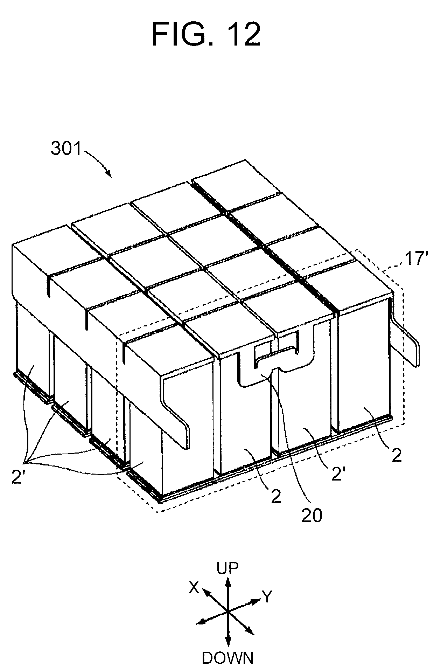

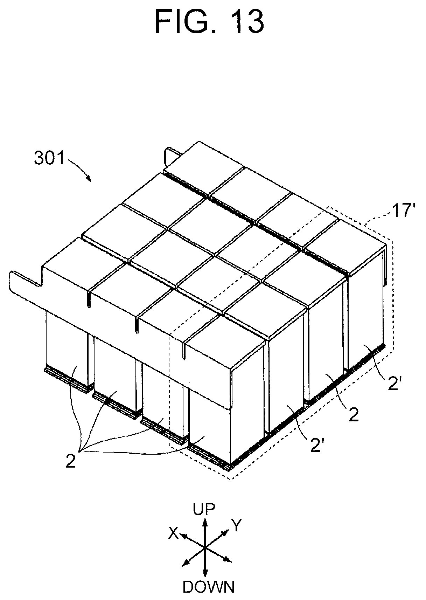

Next, with reference to FIG. 12 through FIG. 14, a description is given of a third embodiment of the present invention. It should be noted that parts that are identical to those of the first or second embodiments are given the same reference numerals and descriptions thereof are omitted. In addition, reference numeral 17' in FIG. 12 and FIG. 13 denotes series groups of the third embodiment.

The thermoelectric conversion module 301 of the third embodiment is a so-called pi-type thermoelectric conversion module consisting of n-type thermoelectric conversion elements 2 and p-type thermoelectric conversion elements 2', electrically connected. As shown in FIG. 12, the elements are arranged p-type, n-type, p-type, n-type, in that order, from the proximal end in the Y direction. In the X direction, four thermoelectric conversion elements of the same type are arrayed.

In the so-called pi-type thermoelectric conversion module, the p-type thermoelectric conversion element 2' functions as a connector that connects the first electrode with the second electrode to which the thermoelectric conversion elements are electrically connected. As a result, in the so-called pi-type thermoelectric conversion module, there is no connector.

The first electrodes 3 positioned between the two integrated first electrodes 9 in the Y direction are electrically connected by adjacent first electrodes in the Y direction. In the third embodiment, adjacent first electrodes 3 in the Y direction are electrically connected by a downwardly bent W-shaped flexural flange 20 that depends from the proximal side edge in the X direction of the first electrodes 3.

The W-shaped flexural flanges 20 are constructed of a flexural part that depends from the side edge of the first electrodes 3 and a bent part that connects two flexural parts to each other in the Y direction. Since the coefficient of thermal expansion differs between the n-type thermoelectric conversion elements 2 and the p-type thermoelectric conversion elements 2', the W-shaped flexural flanges 20 are formed in the shape of a W to deform easily and thereby accommodate these differences in expansion (and contraction). In addition, the W-shaped flexural flanges 20 can absorb changes in the distance between thermoelectric conversion elements 2 in the Y direction (the horizontal direction) due to thermal expansion of the base 5. The W-shaped flexural flanges 20 of the present embodiment are thus the equivalent of a tracking part in the present invention.

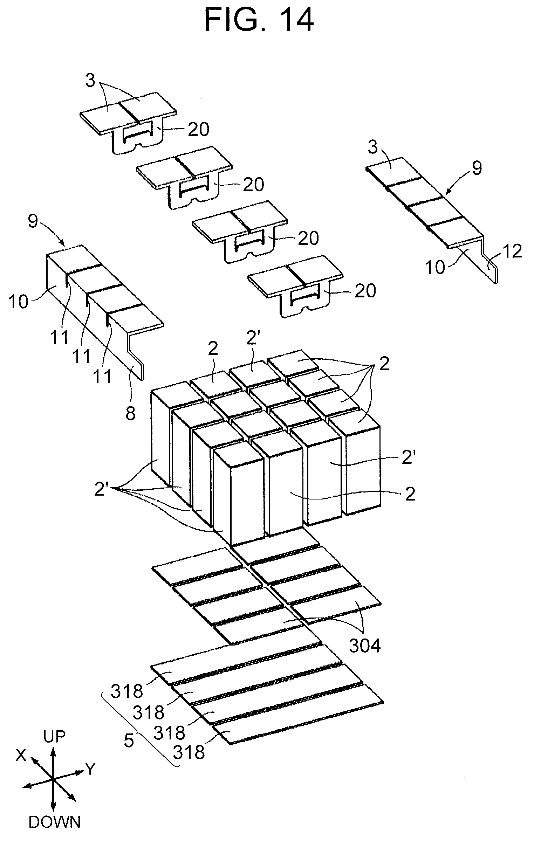

Moreover, as shown in the exploded view of FIG. 14, second electrodes 304 of the third embodiment are configured such that second electrodes of the n-type thermoelectric conversion elements 2 and second electrodes of the p-type thermoelectric conversion elements 2' are connected and integrated in the Y direction so as to electrically connected n-type thermoelectric conversion elements 2 and p-type thermoelectric conversion elements 2' adjacent in the Y direction.

In the thermoelectric conversion module 301 of the third embodiment, the four thermoelectric conversion elements 2, 2' consisting of alternating p-type and n-type thermoelectric conversion elements aligned in the Y direction comprise one series group 17', with four series groups 17' disposed in the X direction. The series groups 17' are connected in parallel by the integrated first electrodes 9 provided at both ends in the Y direction.

The first terminal part 8 is provided to the integrated first electrode 9 on the proximal end. Similarly, the second terminal part 12 is provided to the first terminal part 8 on the distal end. The first integrated terminals 9 of the third embodiment are provided bilaterally symmetrically. In addition, the base 5 of the third embodiment is constructed of four sub-substrates 318 divided in the X direction, corresponding to the series groups 17'.

The thermoelectric conversion module 301 of the third embodiment also provides the same effects of improved reliability, high induced voltage, and ease of size alteration as the first and second embodiments do.

It should be noted that the second electrodes 304 aligned in the X direction of the third embodiment may be configured as integrated units like the second electrodes of the fourth embodiment to be described below. In that case, the four p-type thermoelectric conversion elements 2' and the four n-type thermoelectric conversion elements 2 on the proximal end comprise one parallel group. In this case, the base 5 may be divided into two sub-substrates in the Y direction, like the base 5 of the fourth embodiment to be described below.

Moreover, the same variations as those of the first embodiment and the second embodiment are also applicable to the third embodiment. The positions of the n-type thermoelectric conversion elements 2 and the p-type thermoelectric conversion elements 2' are interchangeable. The orientation of the first terminal part 8 and the second terminal part 12 can be altered as convenient upon considering whether or not to link thermoelectric conversion modules 1 together with the binding member 19 as in the first embodiment.

### Fourth Embodiment

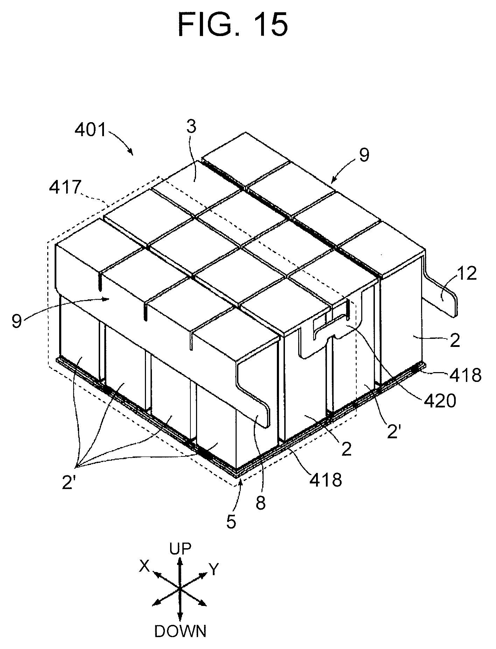

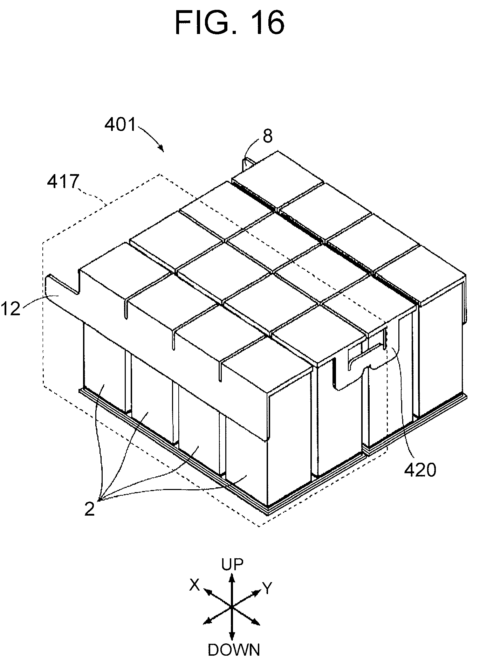

Next, with reference to FIG. 15 through FIG. 17, a description is given of a fourth embodiment of the present invention. It should be noted that parts that are identical to those of the first through third embodiments are given the same reference numerals and descriptions thereof are omitted. In addition, reference numeral 417 in FIG. 15 and FIG. 16 denotes parallel groups of the fourth embodiment.

A thermoelectric conversion module 401 of the fourth embodiment, like the third embodiment, is a so-called pi-type thermoelectric conversion module consisting of n-type thermoelectric conversion elements 2 and p-type thermoelectric conversion elements 2', electrically connected. The thermoelectric conversion module 401 of the fourth embodiment, compared to the thermoelectric conversion module 301 of the third embodiment, differs in that the second electrodes, the sub-substrates, and first electrodes 3 located between the two integrated first electrodes 3 in the Y direction are connected to each other.

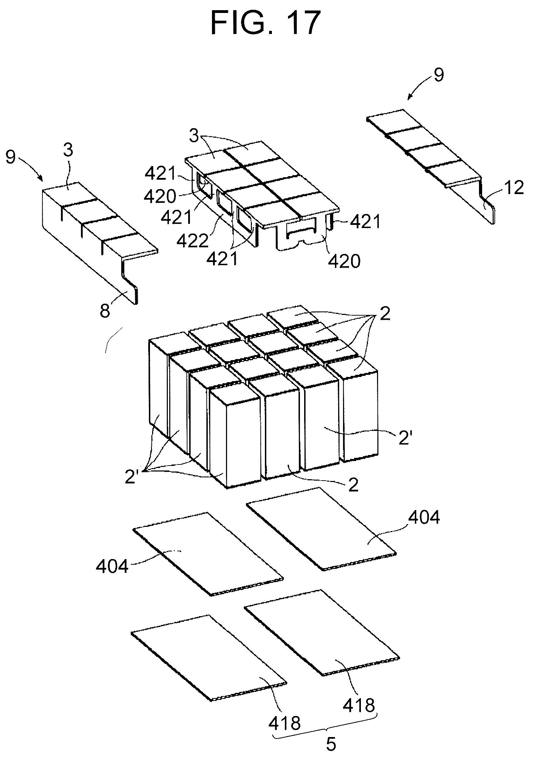

As shown in the exploded diagram of FIG. 17, the eight first electrodes 3 consisting of the four in the X direction located between the two integrated first electrodes 9 in the Y direction times the two in the Y direction are formed by punching them out of a single sheet of metal and bending them with a connecting portion to be described below. The two first electrodes 3 aligned in the Y direction located on the proximal end in the X direction in FIG. 15 and FIG. 17 (the distal end in FIG. 16) are connected to each other by a W-shaped flexural flange 420 bent downward from the proximal side edge in the X direction. The two first electrodes 3 aligned in the Y direction located on the distal end in FIG. 15 and FIG. 17 (the proximal end in FIG. 16) are connected to each other by another W-shaped flexural flange 420 bent downward from the distal side edge in the X direction.

A flexural flange 421 bent downward from the proximal side edge in the Y direction is provided to each of the four first electrodes 3 aligned in the X direction on the proximal end in the Y direction in FIG. 15 and FIG. 17 (the distal end in FIG. 16). The bottom ends of the flexural flanges 421 are linked by a connecting part 422. The four first electrodes 3 are connected over the X direction by the flexural flange 421 and the connecting part 422. Since the same thermoelectric conversion elements 2, 2' are arrayed over the X direction, it is not necessary that the connecting part 422 have the W-shaped form that deforms easily as the W-shaped flexural flanges 420 in the Y direction.

A flexural flange 421 bent downward from the distal side edge in the Y direction is provided to each of the four first electrodes 3 aligned in the X direction and located on the distal end in the Y direction in FIG. 15 and FIG. 17 (the proximal end in FIG. 16). The bottom ends of the flexural flanges 421 are linked by a connecting part 422. The four first electrodes 3 are connected over the X direction by the flexural flange 421 and the connecting part 422.

The second electrodes 404 of the fourth embodiment are configured as an integrated unit with the second electrodes 304 of the third embodiment arrayed in the X direction. The base 5 of the fourth embodiment is configured as two sub-substrates 418 divided in the Y direction, corresponding to the parallel groups 417.

The thermoelectric conversion module 401 of the fourth embodiment can also provide the same effects of improved reliability, high induced voltage, and ease of size alteration as the first through third embodiments do.

It should be noted that the second electrode 404 and the divided substrate 418 of the fourth embodiment can be replaced by the second electrode 304 and the divided substrate 318 of the third embodiment.

Moreover, variations like those of the first through third embodiments are also applicable to the thermoelectric conversion module 401 of the fourth embodiment. In addition, the orientations of the first terminal part 8 and the second terminal part 12 can be altered as convenient upon considering whether or not to link thermoelectric conversion modules 1 together with the binding member 19.

### List of Reference Numbers

- 1: Thermoelectric conversion module
- 2: Thermoelectric conversion element
- 3: First electrode
- 4: Second electrode
- 5: Base
- 6: Integrated second electrode
- 6a: Recessed portion
- 7: Bent part
- 8: First terminal part
- 9: Integrated first electrode
- 10: Bent part
- 11: Slits
- 12: Second terminal part
- 13: Connector
- 14: Cutout
- 15: Folded part
- 16: Z-shaped member
- 17: Parallel group
- 18: Sub-substrate
- 19: Binding member
- 20: W-shaped flexural flange
- 213: Connector (second embodiment)
- 213a: Notched groove (tracking part)

## Claims

1. A thermoelectric conversion module (1), **characterized by**:
a plurality of first electrodes (3);
a plurality of thermoelectric conversion elements (2), each electrically connected to one of the first electrodes (3) at one end thereof; and
a plurality of second electrodes (4), each electrically connected to another end of the thermoelectric conversion elements (2),
a plurality of series groups (17') connecting the thermoelectric conversion elements (2) in series,
the series groups (17') connected in parallel.

2. A thermoelectric conversion module (1), **characterized by**:
a plurality of first electrodes (3);
a plurality of thermoelectric conversion elements (2), each electrically connected to one of the first electrodes (3) at one end thereof; and
a plurality of second electrodes (4), each electrically connected to another end of the thermoelectric conversion elements (2),
a plurality of parallel groups (17, 217, 417) connecting the thermoelectric conversion elements (2) in parallel,
the parallel groups (17, 217, 417) connected in series.

3. The thermoelectric conversion module (1) as claimed in claim 1 or claim 2, **characterized by** a pair of terminal parts (8, 12) to input and output electricity,
one of the pair of terminal parts (8, 12) positioned adjacent another terminal part of an adjacent thermoelectric conversion module (1) when a plurality of thermoelectric conversion modules (1) are aligned,
the other of the pair of terminal parts (8, 12) and the other terminal part of the adjacent thermoelectric conversion module (1) linkable by a binding member (19).

4. The thermoelectric conversion module (1) as claimed in any of claims 1 through 3,
**characterized in that** a guide (61) that positions the thermoelectric conversion elements (2) is provided to either the first electrodes (3) or the second electrodes (4).

5. The thermoelectric conversion module (1) as claimed in any of claims 1 through 4,
**characterized in that** the first electrodes (3) or the second electrodes (4) are formed of a member containing a layer of brazing material.

6. The thermoelectric conversion module (1) as claimed in any of claims 1 through 5,
**characterized by** a base (5) on which are arranged either the first electrodes (3) or the second electrodes (4),
**characterized in that** the base (5) is divided into a plurality of parts (18).

7. The thermoelectric conversion module (1) as claimed in claim 6, **characterized in that** the base (5) is divided by the parallel groups (17, 217, 417) or the series groups (17').

8. The thermoelectric conversion module (1) as claimed in any one of claims 1 through 7, **characterized in that** the plurality of thermoelectric conversion elements (2) are composed of one of either n-type or p-type thermoelectric conversion elements (2),
**characterized by** a connector (13, 213) that electrically connects the first electrodes (3) and the second electrodes (4) electrically connected to adjacent thermoelectric conversion elements (2),
**characterized in that** a tracking portion (20, 2013, 213) is provided to the connector (13,213) and is configured to heighten an ability of the connector (13, 213) to track deformation of the thermoelectric conversion module (1) due to thermal expansion and thermal contraction of the thermoelectric conversion elements (2).

9. The thermoelectric conversion module (1) as claimed in any one of claims 1 through 7, **characterized in that** the plurality of thermoelectric conversion elements (2) are composed of n-type and p-type thermoelectric conversion elements (2),
adjacent n-type thermoelectric conversion elements (2) and p-type thermoelectric conversion elements (2) are connected by either first electrodes (3) or second electrodes (4) connected to each other;
the first electrodes (3) and second electrodes (4) connected to each other by an absorbing part (20) that absorbs deformation due to thermal expansion of the thermoelectric conversion elements (2), the absorbing part (20) connecting adjacent ends of the first electrodes (3) or the second electrodes (4) after bending from one end of the first electrode (3) or the second electrode back toward the other of the first electrode (3) and the second electrode (4).

10. The thermoelectric conversion module (1) of any one of claims 1 through 9, **characterized by** a pair of terminal parts (8, 12) to input and output electricity,
**characterized in that** at least one of the terminal parts (8, 12) is provided to the first electrodes (3) or the second electrodes (4) electrically connected to the parallel groups (17, 217, 417) or the series groups (17') via a bent part (7, 10) that is bent along a side edge of one of the parallel group (17, 217, 417) or the series group (17') and which suppresses a rise in temperature of at least one of the terminal parts (8, 12).

11. The thermoelectric conversion module (1) of any one of claims 1 through 10, **characterized in that** the plurality of first electrodes (3) are provided so that each first electrode (3) corresponds to a corresponding one of the thermoelectric conversion elements (2),
**characterized in that** the second electrodes (4) are fixedly mounted on the base (5).

12. The thermoelectric conversion module (1) as claimed in claim 11, **characterized in that** the second electrodes (4) are formed into integrated units (6) corresponding to the parallel groups (17, 217, 417).
